# EUROPEAN PATENT APPLICATION

(11) **EP 4 807 971 A1**
(43) Date of publication of application: **16.09.2026**
(21) Application number: 24888559.2
(22) Date of filing: 25.10.2024
(51) Int. Cl.: H02M 7/48

(54) **POWER CONVERSION DEVICE**

(30) Priority: 09.11.2023 JP 2023191819
(71) Applicant: DENSO CORPORATION, Kariya-city, Aichi 448-8661 (JP)
(72) Inventor: MATSUURA Yusaku, Kariya-city Aichi 448-8661 (JP)
(74) Representative: TBK
(86) International application number: PCT/JP2024/038090
(87) International publication number: WO 2025/100262

(57) **Abstract**

A power conversion device includes a semiconductor module (12U, 12V, 12W), a first electrical component (20), a second electrical component (70), a housing (160), and a cooler (240). The semiconductor module has a signal terminal (11D) connected to a board (15). The housing has a bottom (171). In a first placement portion (177), the semiconductor module is disposed on an inner bottom surface side and the second electrical component is disposed on an outer bottom surface side. A second placement portion (173) is disposed at a position farther from the board than the first placement portion, and the first electrical component is disposed on an inner bottom surface side. The first placement portion includes, inside thereof, a second flow path (204) adjacent to the semiconductor module, a third flow path (207) adjacent to the second electrical component, and a wall (211) separating the second flow path and the third flow path. The semiconductor module is sandwiched between the cooler and the first placement portion.

## Description

### CROSS REFERENCE TO RELATED APPLICATION

This application is based on Japanese Patent Application No. 2023-191819 filed on November 9, 2023, the contents of which are incorporated herein by reference in their entirety.

### TECHNICAL FIELD

The disclosure described in this specification relates to a power conversion device.

### BACKGROUND ART

A power conversion device described in Patent Literature 1 includes a switching unit, a smoothing capacitor, a noise filter, a control board, a cooler, and a housing that accommodates these elements.

### PRIOR ART LITERATURE

### PATENT LITERATURE

Patent Literature 1 : JP 2022-107381 A

### SUMMARY OF INVENTION

The switching unit is accommodated in the housing between a bottom wall and the control board. A gate terminal of the switching unit extends to the control board and is connected to the control board. A semiconductor module included in the switching unit is held by the cooler and is cooled by a coolant flowing through the cooler. Further, a cooling path through which coolant can flow is formed in the bottom wall. The capacitor is disposed on an inner bottom surface of the bottom wall, and the noise filter is disposed on an outer bottom surface of the bottom wall. The capacitor and the noise filter are cooled by the coolant flowing through the cooling path.

If an attempt is made to cool the semiconductor module of Patent Literature 1 without using the cooler by disposing the semiconductor module on the bottom wall, the gate terminal becomes longer. According to this, there is a possibility that connection failure between the gate terminal and the control board may occur due to vibration or the like. In the structure of Patent Literature 1, it was difficult to efficiently dissipate heat of the semiconductor module, the capacitor, and the noise filter to the bottom while maintaining good connection between the gate terminal and the control board.

An object of the present disclosure is to provide a power conversion device which is capable of efficiently dissipating heat of a plurality of electrical components including a semiconductor module to the bottom while maintaining favorable connection between the semiconductor module and a board.

A power conversion device according to an aspect of the present disclosure includes:
a semiconductor module having a thickness in one direction and including a signal terminal that extends in the one direction and is connected to a board;
a first electrical component electrically connected to the semiconductor module;
a conductive member connecting a battery and the first electrical component;
a second electrical component electrically or magnetically connected to the conductive member;
a housing including a bottom that has an inner bottom surface facing the board and an outer bottom surface located on a back side of the inner bottom surface, and to which the semiconductor module, the first electrical component, and the second electrical component are thermally connected; and
a cooler including a first flow path for cooling the semiconductor module, in which:
   the bottom includes:
      a first placement portion in which the semiconductor module is disposed on an inner bottom surface side and the second electrical component is disposed on an outer bottom surface side;
      a second placement portion disposed at a position farther from the board in the one direction than the first placement portion, and in which the first electrical component is disposed on the inner bottom surface side; and
      a connecting portion connecting the first placement portion and the second placement portion;
   the first placement portion includes, inside thereof, a second flow path disposed adjacent to the semiconductor module, a third flow path disposed adjacent to the second electrical component, and a wall separating the second flow path and the third flow path; and
   the semiconductor module is sandwiched between the cooler and the first placement portion.

Heat of the semiconductor module is dissipated to the cooler and the first placement portion. Heat of the first electrical component is dissipated to the second placement portion. Heat of the second electrical component is dissipated to the first placement portion. Further, since the semiconductor module is located near the board in a state where the semiconductor module is disposed in the first placement portion, the connection between the signal terminal and the board can be kept favorable against vibration or the like. It has become possible to efficiently cool a plurality of electrical components including the semiconductor module at the bottom while maintaining favorable connection between the signal terminal and the board.

Note that reference numerals in parentheses described in the appended claims merely indicate correspondence with configurations described in embodiments to be described later, and do not limit the technical scope in any way.

### BRIEF DESCRIPTION OF DRAWINGS

FIG. 1 is an electric circuit diagram for explaining an in-vehicle system.
FIG. 2 is a plan view of a power conversion device as viewed from a cover side.
FIG. 3 is a plan view of the power conversion device from which the cover, a board, and a bracket are removed from the state shown in FIG. 2.
FIG. 4 is a plan view of a main body portion as viewed from the cover side.
FIG. 5 is a cross-sectional view of the power conversion device taken along a line V-V of FIG. 2.
FIG. 6 is a plan view of a first forming portion as viewed from the cover side.
FIG. 7 is a plan view of the first forming portion as viewed from a flat portion side.
FIG. 8 is a cross-sectional view taken along a line VIII-VIII of FIG. 2.
FIG. 9 is a cross-sectional view of a second embodiment.

### DESCRIPTION OF EMBODIMENTS

Hereinafter, a plurality of embodiments for carrying out the present disclosure will be described with reference to the drawings. In each embodiment, portions corresponding to matters described in a preceding embodiment may be denoted by the same reference numerals, and redundant descriptions may be omitted. When only a part of a configuration is described in an embodiment, other embodiments described earlier can be applied to other parts of the configuration.

Not only combinations between parts for which it is explicitly indicated that combination is possible in each embodiment, but also, as long as there is no particular hindrance to combination, it is also possible to partially combine embodiments with each other, an embodiment with a modification, and modifications with each other even if not explicitly indicated.

### (First Embodiment)

### <In-vehicle System>

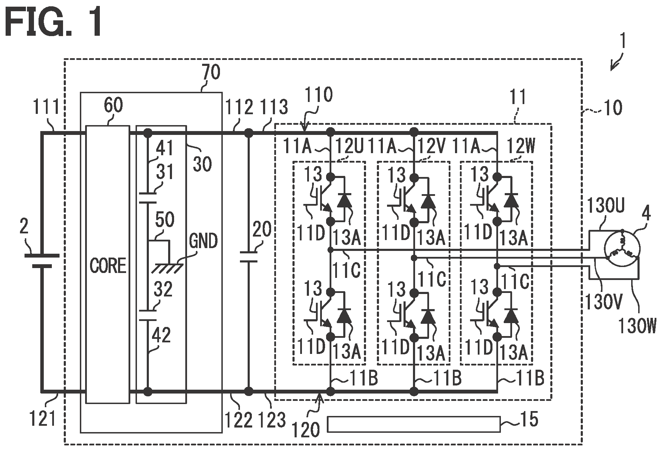

First, FIG. 1 is an electric circuit diagram for explaining an in-vehicle system 1. This in-vehicle system 1 constitutes a system for an electric vehicle. The in-vehicle system 1 includes a battery 2 and an integrated electric-mechanical unit. The integrated electric-mechanical unit includes a power conversion device 10 and a motor 4.

The in-vehicle system 1 also includes a plurality of ECUs (not shown). These ECUs transmit and receive signals to and from each other via bus wirings. The plurality of ECUs cooperate to control the electric vehicle. By control of the plurality of ECUs, motoring and regeneration of the motor 4 according to the SOC of the battery 2 are controlled.

The ECU includes at least one arithmetic processing device (CPU) and at least one memory device (MMR) as a storage medium for storing programs and data. The ECU is provided by a microcomputer including a storage medium readable by a computer or processor. The storage medium is a non-transitory tangible storage medium that non-temporarily stores a program readable by a computer or processor. The storage medium can be provided by a semiconductor memory, a magnetic disk, or the like. Hereinafter, components of the in-vehicle system 1 will be individually outlined.

The battery 2 includes a plurality of secondary batteries. The plurality of secondary batteries constitute a battery stack connected in series. The SOC of this battery stack corresponds to the SOC of the battery 2. As the secondary batteries, a lithium-ion secondary battery, a nickel-metal hydride secondary battery, an organic radical battery, or the like can be adopted.

The power conversion device 10 performs power conversion between the battery 2 and the motor 4. The power conversion device 10 converts DC power of the battery 2 into AC power. The power conversion device 10 converts AC power generated by power generation (regeneration) of the motor 4 into DC power.

The motor 4 is coupled to an output shaft of an electric vehicle (not shown). Rotational energy of the motor 4 is transmitted to driving wheels of the electric vehicle via the output shaft. Conversely, rotational energy of the driving wheels is transmitted to the motor 4 via the output shaft. The motor 4 performs motoring by the AC power supplied from the power conversion device 10. Accordingly, propulsive force is applied to the driving wheels. The motor 4 performs regeneration by rotational energy transmitted from the driving wheels. The AC power generated by this regeneration is converted into the DC power by the power conversion device 10. This DC power is supplied to the battery 2. The DC power is also supplied to various electric loads mounted on the electric vehicle.

### <Power Conversion Device>

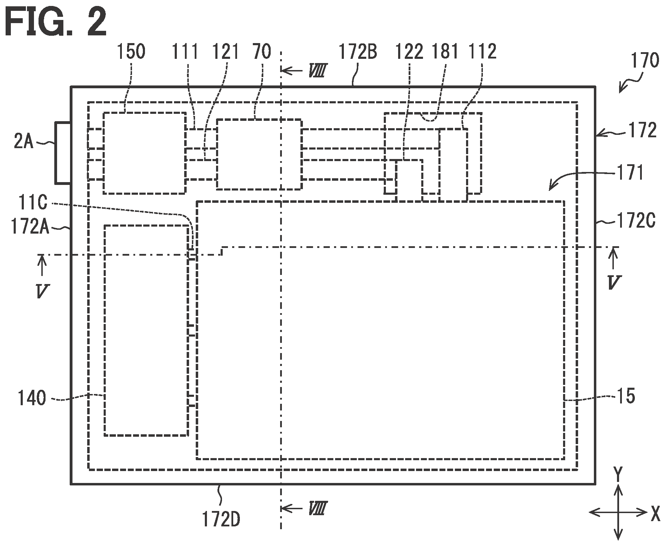

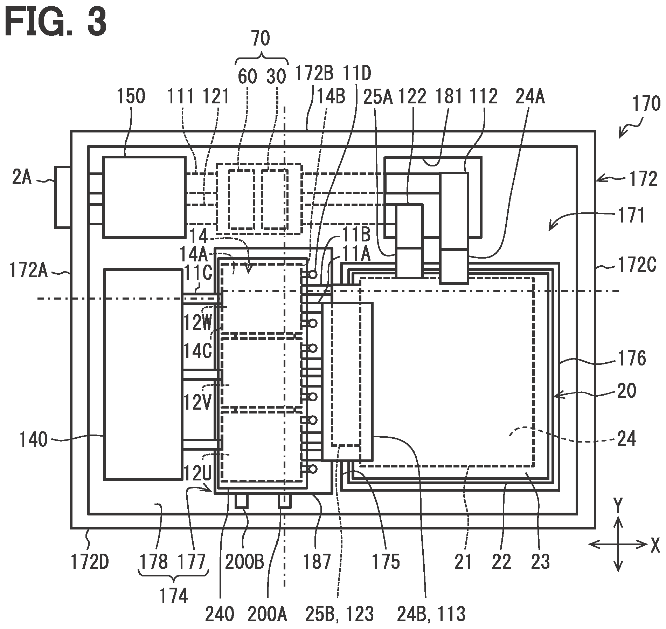

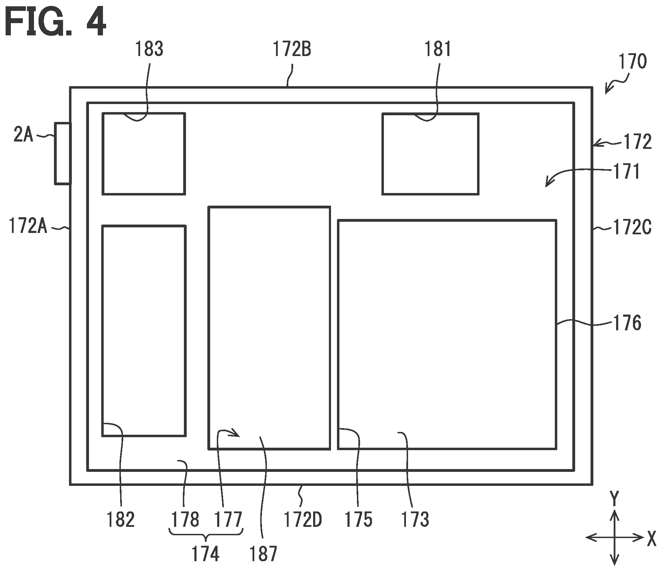

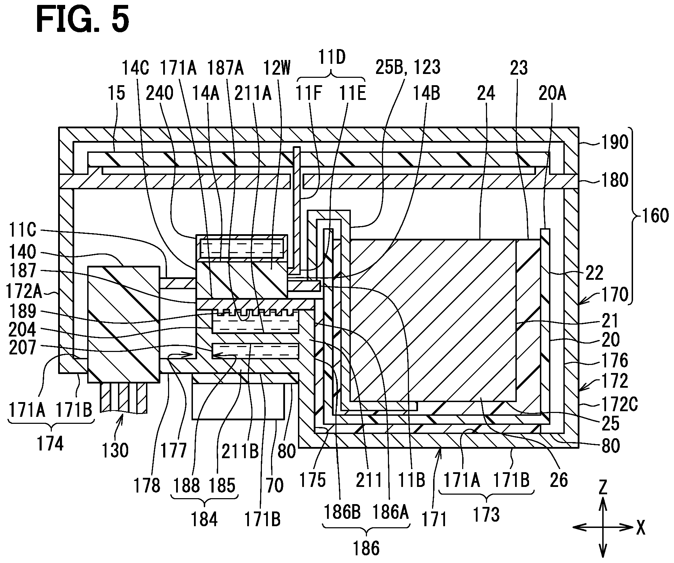

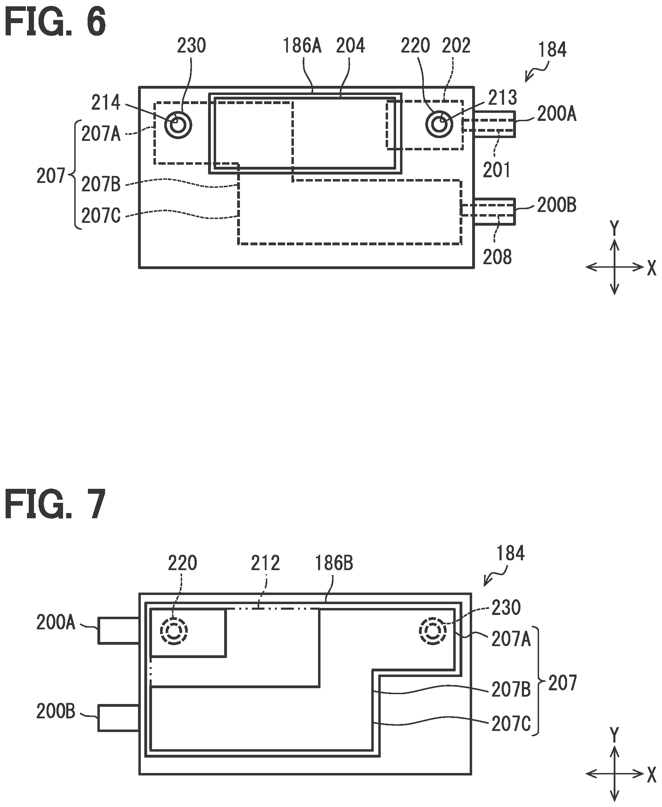

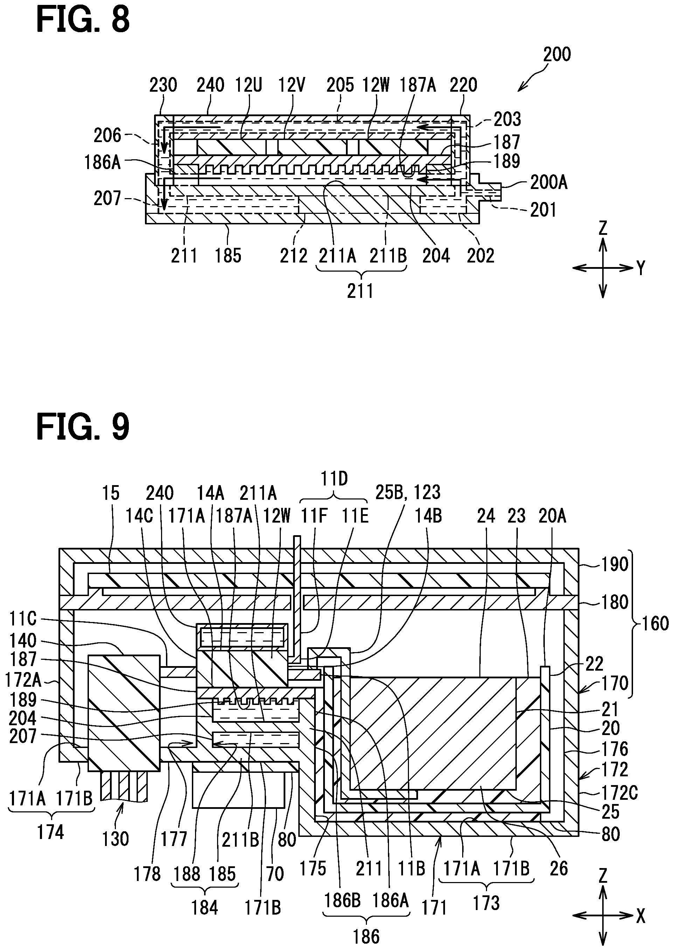

Next, the power conversion device 10 will be described. The power conversion device 10 of the present embodiment includes components of an inverter 11. The power conversion device 10 may include components of a converter in addition to the components of the inverter 11. FIG. 2 is a plan view of the power conversion device 10 as viewed from a cover 190 side. FIG. 3 is a plan view obtained by removing the cover 190, a control board 15, and a bracket 180 from FIG. 2. FIG. 4 is a plan view of a main body portion 170 as viewed from the cover 190 side. FIG. 5 is a cross-sectional view of the power conversion device 10 taken along a line V-V of FIG. 2. FIG. 6 is a plan view of a first forming portion 184 as viewed from the cover 190 side. FIG. 7 is a plan view of the first forming portion 184 as viewed from a flat portion 185 side. FIG. 8 is a cross-sectional view taken along a line VIII-VIII of FIG. 2. Note that in FIG. 3, a cross-sectional line is added at the same position as in FIG. 2.

The power conversion device 10 includes, as wirings, a high-potential-side busbar 110 and a low-potential-side busbar 120. The high-potential-side busbar 110 is electrically connected to a positive electrode of the battery 2. The low-potential-side busbar 120 is electrically connected to a negative electrode of the battery 2. The power conversion device 10 also includes a U-phase busbar 130U, a V-phase busbar 130V, and a W-phase busbar 130W connected to the motor 4. The U-phase busbar 130U, the V-phase busbar 130V, and the W-phase busbar 130W may collectively be referred to as connecting busbars 130.

In addition to the wirings described above, the power conversion device 10 includes the inverter 11, the control board 15, a smoothing capacitor 20, a noise filter 70, a heat dissipation member 80, a motor connector 140, a terminal block 150, and a housing 160 accommodating these components. The noise filter 70 includes a Y capacitor 30 and a magnetic core 60. The power conversion device 10 may also include a current sensor or the like (not shown). The noise filter 70 may include only one of the Y capacitor 30 and the magnetic core 60. The smoothing capacitor 20 may be referred to as a first electrical component. The noise filter 70 may be referred to as a second electrical component. The control board 15 may simply be referred to as a board.

The inverter 11, the smoothing capacitor 20, and the noise filter 70 are connected in parallel to the high-potential-side busbar 110 and the low-potential-side busbar 120. The high-potential-side busbar 110 includes a high-potential-side first connection portion 111, a high-potential-side second connection portion 112, and a high-potential-side third connection portion 113. The three high-potential-side connection portions 111, 112, 113 are continuous in this order. Similarly, the low-potential-side busbar 120 includes a low-potential-side first connection portion 121, a low-potential-side second connection portion 122, and a low-potential-side third connection portion 123. The low-potential-side connection portions 121, 122, 123 are continuous in this order.

The high-potential-side first connection portion 111 and the low-potential-side first connection portion 121 may collectively be referred to as first connection portions 111, 121. The high-potential-side second connection portion 112 and the low-potential-side second connection portion 122 may collectively be referred to as second connection portions 112, 122. The high-potential-side third connection portion 113 and the low-potential-side third connection portion 123 may collectively be referred to as third connection portions 113, 123. The battery 2 and the noise filter 70 are connected via the first connection portions 111, 121. The noise filter 70 and the smoothing capacitor 20 are connected via the second connection portions 112, 122. The smoothing capacitor 20 and the inverter 11 are connected via the third connection portions 113, 123. The battery 2 and the smoothing capacitor 20 are electrically connected via the first connection portions 111, 121, the noise filter 70, and the second connection portions 112, 122. The first connection portions 111, 121 and the second connection portions 112, 122 may be referred to as conductive members.

In the present embodiment, more specifically regarding the first connection portions 111, 121, the battery 2 and the Y capacitor 30 (described later) are connected via the first connection portions 111, 121. The magnetic core 60 (described later) annularly surrounds the first connection portions 111, 121. More specifically regarding the second connection portions 112, 122, the Y capacitor 30 and the smoothing capacitor 20 are connected via the second connection portions 112, 122. Note that the position on which the magnetic core 60 is disposed is not limited to the first connection portions 111, 121. As another example, the magnetic core 60 may be disposed on the second connection portions 112, 122.

The inverter 11 includes three-phase semiconductor modules 12U, 12V, 12W. The three-phase semiconductor modules 12U, 12V, 12W include a U-phase semiconductor module 12U, a V-phase semiconductor module 12V, and a W-phase semiconductor module 12W. The U-phase semiconductor module 12U is electrically connected to a U-phase winding of the motor 4 via the U-phase busbar 130U. The same applies to the V-phase semiconductor module 12V and the W-phase semiconductor module 12W, which are electrically connected to corresponding windings of the motor 4 via corresponding connecting busbars 130.

Each of the semiconductor modules 12U, 12V, 12W includes two switching elements 13 and two diodes 13A. The two switching elements 13 are connected in series between the high-potential-side busbar 110 and the low-potential-side busbar 120. A high-potential-side input terminal 11A connected to the high-potential-side busbar 110 is connected to a collector electrode of one of the two switching elements 13 disposed on the high-potential side. A low-potential-side input terminal 11B connected to the low-potential-side busbar 120 is connected to an emitter of one of the two switching elements 13 disposed on the low-potential side. An anode of the diode 13A is connected to an emitter of the corresponding switching element 13. A cathode of the diode 13A is connected to a collector of the corresponding switching element 13.

A motor terminal 11C connected to the motor 4 is connected to an emitter of the switching element 13 on the high-potential side and a collector of the switching element 13 on the N side. The plurality of switching elements 13 convert the DC power supplied from the battery 2 into the AC power with which the motor 4 can be driven. The power thus converted is supplied to the motor 4 via the connecting busbar 130.

The two switching elements 13 also include signal terminals 11D electrically connected to the control board 15. The signal terminal 11D is connected to a gate electrode of the corresponding switching element 13. An on/off signal for the switching element 13 is input from the control board 15 via the signal terminal 11D. Hereinafter, the high-potential-side input terminal 11A, the low-potential-side input terminal 11B, the motor terminal 11C, and the signal terminal 11D may collectively simply be referred to as terminals 11A, 11B, 11C, 11D.

In addition to the switching elements 13, the diodes 13A, and the terminals 11A, 11B, 11C, 11D described above, each of the semiconductor modules 12U, 12V, 12W includes a sealing member 14 that seals the switching elements 13, the diodes 13A and the terminals 11A, 11B, 11C, 11D. The sealing member 14 is mainly formed of resin. All of the switching elements 13, all of the diodes 13A, and portions of the terminals 11A, 11B, 11C, 11D are accommodated in the sealing member 14. The remaining portions of the terminals 11A, 11B, 11C, 11D are exposed from the sealing member 14. The mechanical configuration of the semiconductor modules 12U, 12V, 12W will be described in detail later.

The control board 15 controls to turn on and off the plurality of switching elements 13. A control circuit for controlling on and off of the plurality of switching elements 13 is mounted on the control board 15. Note that the ECU described above may be mounted on the control board 15. The signal terminals 11D of the plurality of switching elements 13 extend toward the control board 15. The signal terminals 11D of the plurality of switching elements 13 are inserted through the control board 15 and solder-connected.

The smoothing capacitor 20 mainly smooths the DC voltage supplied from the battery 2. The smoothing capacitor 20 includes a capacitor element 21, a capacitor case 22, and a sealing resin 23. The capacitor element 21 and the sealing resin 23 are accommodated inside the capacitor case 22. The capacitor element 21 is fixed to an inner surface of the capacitor case 22 by the sealing resin 23. As an example, the capacitor element 21 is a film capacitor. The film capacitor is configured such that a metal vapor-deposited electrode is provided on a dielectric film and the dielectric film is wound so that the metal vapor-deposited electrodes face each other. Metal is thermally sprayed onto both end faces of the film capacitor to form metallized electrodes. One metallized electrode is electrically connected to the metal vapor-deposited electrode.

The capacitor element 21 has a three-dimensional shape with a certain volume. The capacitor element 21 may be provided, for example, as a three-dimensional shape such as a cylinder or an elliptic cylinder. The capacitor element 21 includes at least two end faces 24, 25 and a side face 26. One end face of the capacitor element 21 is referred to as a first end face 24. A metallized electrode is provided on the first end face 24. A first terminal 24A and a second terminal 24B are connected to the metallized electrode provided on the first end face 24. The other end face of the capacitor element 21 is referred to as a second end face 25. A metallized electrode is provided on the second end face 25. A third terminal 25A and a fourth terminal 25B are connected to the metallized electrode provided on the second end face 25.

The high-potential-side second connection portion 112 is connected to the first terminal 24A. The high-potential-side third connection portion 113 is connected to the second terminal 24B. The low-potential-side second connection portion 122 is connected to the third terminal 25A. The low-potential-side third connection portion 123 is connected to the fourth terminal 25B. The capacitor element 21 and portions of the first terminal 24A to the fourth terminal 25B are sealed by the sealing resin 23, and the remaining portions of the first terminal 24A to the fourth terminal 25B are exposed from the sealing resin 23.

The noise filter 70 includes the Y capacitor 30 and the magnetic core 60. The Y capacitor 30 removes a noise component caused by current flowing through the first connection portions 111, 121 and the second connection portions 112, 122. The Y capacitor 30 includes two capacitor elements 31, 32, two capacitor busbars 41, 42, and a ground busbar 50. Of the two capacitor elements 31, 32, one on the high-potential-side busbar 110 side may be referred to as a high-potential-side capacitor element 31. Of the two capacitor elements 31, 32, one on the low-potential-side busbar 120 side may be referred to as a low-potential-side capacitor element 32.

Of the two capacitor busbars 41, 42, one connected to the high-potential-side capacitor element 31 may be referred to as a high-potential-side capacitor busbar 41. The high-potential-side capacitor element 31 is electrically connected to the high-potential-side busbar 110 via the high-potential-side capacitor busbar 41. Of the two capacitor busbars 41, 42, one connected to the low-potential-side capacitor element 32 may be referred to as a low-potential-side capacitor busbar 42. The low-potential-side capacitor element 32 is electrically connected to the low-potential-side busbar 120 via the low-potential-side capacitor busbar 42.

The ground busbar 50 includes a high-potential-side GND terminal connected to the high-potential-side capacitor element 31, a low-potential-side GND terminal connected to the low-potential-side capacitor element 32, and a GND connection terminal connected to ground via the housing 160. The ground busbar 50 extends so as to connect the high-potential-side GND terminal, the low-potential-side GND terminal, and the GND connection terminal. The ground busbar 50 is connected to the capacitor elements 31, 32 and is electrically connected to ground. The capacitor elements 31, 32 remove the noise component described above from the inverter 11 by causing the noise component to flow to the body ground via the ground busbar 50.

The magnetic core 60 removes a noise component caused by current flowing through the first connection portions 111, 121. Examples of main materials of the magnetic core 60 include ferrite, electromagnetic steel sheet, and amorphous material. The magnetic core 60 is formed by sealing a magnetic material with an insulating member. The magnetic core 60 is formed, for example, in a ring shape. The high-potential-side first connection portion 111 and the low-potential-side first connection portion 121 are passed through a hole surrounded by the magnetic core 60. According to this, the noise component caused by current flowing through the first connection portions 111, 121 can be removed by the magnetic core 60.

The heat dissipation member 80 is a heat dissipation sheet, a gap filler, heat dissipation grease, or the like. The heat dissipation member 80 has a thermal conductivity higher than that of air. The heat dissipation member 80 has an insulating property. The heat dissipation member 80 is provided between the smoothing capacitor 20 and a lower bottom 173 (described later), between the smoothing capacitor 20 and a connecting portion 175 (described later), and between the noise filter 70 and an upper bottom 174 (described later). According to this, heat is efficiently dissipated from the smoothing capacitor 20 and the noise filter 70 to a bottom 171 (described later). The smoothing capacitor 20 and the lower bottom 173, the smoothing capacitor 20 and the connecting portion 175, and the noise filter 70 and the upper bottom 174 are in close contact with each other via the heat dissipation member 80. The noise filter 70 is thermally connected to the upper bottom 174. The smoothing capacitor 20 is thermally connected to the lower bottom 173 and the connecting portion 175. Note that the heat dissipation member 80 does not have to be provided at all three locations described above, and may be provided at least at one of the three locations described above.

### <Mechanical Configuration of Power Conversion Device>

Hereinafter, a thickness direction of the bottom 171 of the housing 160 is defined as a Z direction, and one direction orthogonal to the Z direction is defined as an X direction. The Z direction may be referred to as one direction. The X direction may be referred to as an arrangement direction. A direction orthogonal to both the Z direction and the X direction is defined as a Y direction. A direction orthogonal to the Z direction may be referred to as a planar direction. Unless otherwise specified, a shape as viewed in plan from the Z direction, in other words, a shape along an XY plane defined by the X direction and the Y direction, is referred to as a planar shape. Also, a plan view from the Z direction may simply be referred to as a plan view.

The housing 160 includes the main body portion 170, the bracket 180, and the cover 190. The main body portion 170, the bracket 180, and the cover 190 are manufactured, for example, by aluminum die casting. The main body portion 170 has a box shape including the bottom 171 and a side wall 172. An accommodation space is defined inside by the bottom 171 and the side wall 172. The bracket 180 is provided at a tip end of the side wall 172 so as to close an opening defined by the side wall 172. The cover 190 is provided on an opposite side of the main body portion 170 via the bracket 180. The bracket 180 is covered by the cover 190. A space is provided between the bracket 180 and the cover 190.

Hereinafter, the high-potential-side busbar 110, the low-potential-side busbar 120, and the connecting busbar 130 may collectively be referred to as busbars 110, 120, 130. The smoothing capacitor 20, the three semiconductor modules 12U, 12V, 12W, a portion of the terminal block 150, a portion of the motor connector 140, and portions of the busbars 110, 120, 130 are accommodated in the accommodation space of the main body portion 170. The noise filter 70 and the remaining portions of the busbars 110, 120, 130 are disposed outside the accommodation space of the main body portion 170. The noise filter 70, the remaining portion of the high-potential-side busbar 110, and the remaining portion of the low-potential-side busbar 120 are fixed to an outer bottom surface 171B (described later). The remaining portion of the connecting busbar 130 extends away from the bottom 171 and is connected to the motor 4. The control board 15 is disposed in a space defined between the bracket 191 and the cover 192. The control board 15 is fixed to the bracket 191. The bracket 191 also includes an insertion hole through which the signal terminal 11D is passed. The signal terminal 11D passes through the insertion hole and is solder-connected to the control board 15.

The bottom 171 of the main body portion 170 has the inner bottom surface 171A and the outer bottom surface 171B arranged in the Z direction. The inner bottom surface 171A is a surface facing the control board 15 in the Z direction. The side wall 172 extends upward from the inner bottom surface 171A in the Z direction. Further, the side wall 172 forms a ring shape in a circumferential direction around the Z direction. The side wall 172 includes a first side wall 172A, a second side wall 172B, a third side wall 172C, and a fourth side wall 172D. The first side wall 172A and the third side wall 172C are arranged and spaced apart from each other in the X direction. The second side wall 172B and the fourth side wall 172D are arranged and spaced apart from each other in the Y direction. The first side wall 172A to the fourth side wall 172D are arranged in clockwise order of the first side wall 172A, the second side wall 172B, the third side wall 172C, and the fourth side wall 172D. A region where a space surrounded by an inner peripheral surface of this side wall 172 and a projection region of the inner bottom surface 171A of the bottom 171 in the Z direction overlap corresponds to the accommodation space of the main body portion 170.

The bottom 171 includes the lower bottom 173 and the upper bottom 174 having different positions of the outer bottom surface 171B. The outer bottom surface 171B of the upper bottom 174 is located closer to the control board 15 than the outer bottom surface 171B of the lower bottom 173. The inner bottom surface 171A of the lower bottom 173 is farther from the control board 15 in the Z direction than the outer bottom surface 171B of the upper bottom 174. The bottom 171 also includes the connecting portion 175 connecting the lower bottom 173 and the upper bottom 174. The lower bottom 173 and the upper bottom 174 are integrally connected via the connecting portion 175. The lower bottom 173 may be referred to as a second placement portion. The connecting portion 175 may extend along the Z direction or may not extend along the Z direction. The connecting portion 175 may extend in any direction as long as it connects the lower bottom 173 and the upper bottom 174.

In the plan view, the upper bottom 174 spreads in a substantially L-shape so as to surround the lower bottom 173. A space surrounded by the lower bottom 173 and the connecting portion 175 is a recess 176 recessed from the upper bottom 174. The smoothing capacitor 20 is accommodated in this recess 176. The upper bottom 174 includes a flow path forming portion 177 and a continuous portion 178 continuously spreading from the flow path forming portion 177 in the planar direction. In the plan view, the recess 176 is located at a corner between the third side wall 172C and the fourth side wall 172D on the bottom 171. The flow path forming portion 177 is disposed on the upper bottom 174 so as to be adjacent to the recess 176 in the X direction. The flow path forming portion 177 may be referred to as a first placement portion.

In the plan view, the continuous portion 178 spreads in a substantially L-shape so as to surround the recess 176 and the flow path forming portion 177. The continuous portion 178 is formed with three holes 181, 182, 183 penetrating through the inner bottom surface 171A and the outer bottom surface 171B. The three holes 181, 182, 183 include a busbar insertion hole 181, a motor connector arrangement hole 182, and a terminal block arrangement hole 183. The busbar insertion hole 181 is aligned with the recess 176 in the Y direction. The motor connector arrangement hole 182 is aligned with the flow path forming portion 177 in the X direction on a side opposite to the recess 176. The terminal block arrangement hole 183 is located at a corner between the first side wall 172A and the second side wall 172B. The terminal block arrangement hole 183 is disposed in a region where a projection region of the busbar insertion hole 181 in the X direction and a projection region of the motor connector arrangement hole 182 in the Y direction overlap. Each of the three holes 181, 182, 183 is not formed in a space between the semiconductor modules 12U, 12V, 12W and the smoothing capacitor 20 with respect to the X direction. Note that the busbar insertion hole 181 may simply be referred to as an insertion hole 181.

The second connection portions 112, 122 are passed through the busbar insertion hole 181. The motor connector 140 is passed through the motor connector arrangement hole 182. The motor connector 140 includes the connecting busbar 130 and a sealing resin sealing the connecting busbar 130. The terminal block 150 is passed through the terminal block arrangement hole 183. The terminal block 150 includes the first connection portions 111, 121 and a sealing resin sealing the first connection portions 111, 121. Details will be described later.

The power conversion device 10 further includes, in addition to the components described above, a first connecting pipe 220, a second connecting pipe 230, and a cooler 240. The first connecting pipe 220, the second connecting pipe 230, the cooler 240, and the flow path forming portion 177 may collectively be referred to as a cooling module 200. The cooling module 200 and components constituting the cooling module 200 will be specifically described below.

### <Cooling Module>

The cooling module 200 includes the flow path forming portion 177, the first connecting pipe 220, the second connecting pipe 230, and the cooler 240. As will be described later in detail, the cooler 240 includes a first flow path 205. The flow path forming portion 177 includes a second flow path 204, a third flow path 207, a fourth flow path 202, a supply flow path 201, and a discharge flow path 208. The first connecting pipe 220 includes a first connecting flow path 203. The second connecting pipe 230 includes a second connecting flow path 206.

The flow path forming portion 177 includes a first forming portion 184 and a second forming portion 187. The first forming portion 184 is a portion continuous with the continuous portion 178 by the same material. Note that the first forming portion 184 and the continuous portion 178 may be separate bodies. Alternatively, a portion of the first forming portion 184 and the continuous portion 178 may be integral, and the remaining portion of the first forming portion 184 and the continuous portion 178 may be separate bodies.

The first forming portion 184 includes a flat portion 185 and a structure portion 188. As an example, the flat portion 185 and the structure portion 188 are continuous by the same material. Note that the flat portion 185 and the structure portion 188 do not have to be continuous by the same material. The flat portion 185 and the structure portion 188 may be connected via a connecting member. The flat portion 185 has a flat shape with a small thickness in the Z direction. The flat portion 185 is continuous with the continuous portion 178 in the planar direction. A plate thickness of the flat portion 185 is the same as a plate thickness of the continuous portion 178. Note that the plate thickness of the flat portion 185 and the plate thickness of the continuous portion 178 may be different. The flat portion 185 has the outer bottom surface 171B. The outer bottom surface 171B of the flat portion 185 and the outer bottom surface 171B of the continuous portion 178 are flush with each other.

The structure portion 188 is a portion constituting the second flow path 204, the third flow path 207, and the fourth flow path 202 through which coolant flows. The second flow path 204, the third flow path 207, and the fourth flow path 202 will be described later. The structure portion 188 includes a base portion 211, a first raised portion 186A, a second raised portion 186B, a partition wall 212, a supply pipe 200A, and a discharge pipe 200B. The base portion 211 has a flat plate shape in the Z direction. The base portion 211 is disposed closer to the control board 15 in the Z direction than the flat portion 185. The base portion 211 may also simply be referred to as a wall. The base portion 211 and the flat portion 185 are disposed spaced apart in the Z direction. The base portion 211 has a front surface 211A facing the control board 15 and a back surface 211B facing the flat portion 185.

As shown in FIGS. 5 and 8, the first raised portion 186A is connected to the front surface 211A. The first raised portion 186A extends in the Z direction so as to be away from the front surface 211A. The first raised portion 186A extends in a ring shape around an axis along the Z direction. A space through which coolant can flow is defined by the base portion 211 and the first raised portion 186A. The second forming portion 187 is disposed at a tip end of the first raised portion 186A.

The second forming portion 187 has a flat shape with a small thickness in the Z direction. The second forming portion 187 is disposed at the tip end of the first raised portion 186A so as to close an opening defined by the first raised portion 186A. The space defined by the base portion 211 and the first raised portion 186A is closed by the second forming portion 187. A second flow path 204 through which coolant can flow is defined by the base portion 211, the first raised portion 186A, and the second forming portion 187.

The second forming portion 187 has the inner bottom surface 171A facing the control board 15. The positions in the Z direction of the inner bottom surface 171A of the continuous portion 178 and the inner bottom surface 171A of the second forming portion 187 are different. The inner bottom surface 171A of the second forming portion 187 is located farther from the outer bottom surface 171B of the upper bottom 174 than the inner bottom surface 171A of the continuous portion 178. The inner bottom surface 171A of the second forming portion 187 is located closer to the control board 15 than the inner bottom surface 171A of the continuous portion 178. The second forming portion 187 also has a main surface 187A facing the base portion 211. A plurality of protrusions 189 extending away from the main surface 187A are provided on the main surface 187A. The protrusions 189 may also be referred to as fins. Since the protrusions 189 come into contact with the coolant, the second forming portion 187 is efficiently cooled. Note that the protrusions 189 do not have to be formed on the second forming portion 187.

As shown in FIG. 6, the first raised portion 186A is included in a projection region of the base portion 211 in the Z direction. The first raised portion 186A is disposed on a central side relative to an edge of the base portion 211. In particular, with respect to the Y direction, the first raised portion 186A is disposed largely on the central side relative to the edge of the base portion 211. In the base portion 211, a first through hole 213 penetrating through the base portion 211 in the Z direction is formed between an edge at one end in the Y direction and the first raised portion 186A. In the base portion 211, a second through hole 214 penetrating through the base portion 211 in the Z direction is formed between an edge at the other end in the Y direction and the first raised portion 186A. The first through hole 213 can also be said to be disposed on one end side in the Y direction of the base portion 211. The second through hole 214 can also be said to be disposed on the other end side in the Y direction of the base portion 211.

As shown in FIGS. 5 and 8, the second raised portion 186B and the partition wall 212 are connected to the back surface 211B. The second raised portion 186B and the partition wall 212 extend in the Z direction so as to be away from the back surface 211B.

The inner bottom surface 171A of the second forming portion 187 and the inner bottom surface 171A of the flat portion 185 are connected by a side surface of the first raised portion 186A, a side surface of the second raised portion 186B, and a side surface of the second forming portion 187. The first raised portion 186A and the second raised portion 186B may collectively be referred to as a raised portion 186. The raised portion 186 extends in the Z direction. The raised portion 186 corresponds to a side wall of the first forming portion 184.

In the upper bottom 174, a thickness in the Z direction of the continuous portion 178 and a thickness in the Z direction of the flow path forming portion 177 are different. The thickness of the flow path forming portion 177 is greater than the thickness of the continuous portion 178. A distance from the inner bottom surface 171A of the flow path forming portion 177 to the control board 15 is shorter than a distance from the inner bottom surface 171A of the continuous portion 178 to the control board 15.

As shown in FIG. 7, the second raised portion 186B extends in a ring shape around an axis along the Z direction. The first through hole 213 and the second through hole 214 are surrounded by the second raised portion 186B. A space through which coolant can flow is defined by the wall 211 and the second raised portion 186B.

The partition wall 212 is connected to an inner surface of the second raised portion 186B. The partition wall 212 divides the space described above into a space overlapping the first through hole 213 and a space overlapping the second through hole 214. As an example, the sizes of the two divided spaces are different. Note that the sizes of the two divided spaces may be the same. The tip end of the second raised portion 186B and the tip end of the partition wall 212 face the flat portion 185.

The space overlapping the first through hole 213 and the space overlapping the second through hole 214 are closed by the flat portion 185. The space overlapping the first through hole 213 and closed by the flat portion 185 may be referred to as a fourth flow path 202. The space overlapping the second through hole 214 and closed by the flat portion 185 may be referred to as a third flow path 207. Coolant can flow through the third flow path 207 and the fourth flow path 202.

In the plan view, the supply pipe 200A and the discharge pipe 200B are disposed at an edge on one end in the Y direction of the base portion 211. At the edge on one end in the Y direction of the base portion 211, the supply pipe 200A and the discharge pipe 200B are disposed so as to straddle the raised portion 186. As shown in FIG. 6, the supply pipe 200A and the discharge pipe 200B are tubes defining hollows inside. The hollow of the supply pipe 200A can also be said to be the supply flow path 201 which is a flow path to which coolant is supplied. The hollow of the discharge pipe 200B can also be said to be the discharge flow path 208 which is a flow path from which coolant is discharged. The supply pipe 200A and the discharge pipe 200B are arranged side by side and spaced apart from each other in the X direction.

The fourth flow path 202 and a part of the third flow path 207 are provided so as to overlap the supply pipe 200A in the X direction. In the plan view, the fourth flow path 202 has a substantially rectangular shape. The fourth flow path 202 is provided on one end side in the Y direction of the wall 211. The fourth flow path 202 is disposed adjacent to the supply pipe 200A in the X direction. The supply flow path 201 has two end portions. Coolant is supplied from one end portion of the supply flow path 201. Another end portion of the supply flow path 201 and the fourth flow path 202 are connected in a manner such that coolant can flow.

In the plan view, the third flow path 207 has a substantially Z-shape. A part of the third flow path 207 is provided on the other end side in the Y direction of the wall 211. The third flow path 207 includes a first flow path piece 207A overlapping the supply pipe 200A in the X direction, a third flow path piece 207C overlapping the discharge pipe 200B in the X direction, and a second flow path piece 207B connecting the first flow path piece 207A and the third flow path piece 207C. The first flow path piece 207A and the third flow path piece 207C extend along the X direction. The second flow path piece 207B extends along the Y direction. The third flow path piece 207C is disposed adjacent to the discharge pipe 200B in the X direction. Coolant is discharged from one end portion of the discharge flow path 208. Another end portion of the discharge flow path 208 and the third flow path piece 207C are connected in a manner such that coolant can flow.

The third flow path 207 and the fourth flow path 202 are divided via the partition wall 212. More specifically, the first flow path piece 207A and the fourth flow path 202 are divided in the X direction by the partition wall 212. The third flow path piece 207C and the fourth flow path 202 are divided in the Y direction by the partition wall 212. The second flow path piece 207B and the fourth flow path 202 are divided in the X direction and the Y direction by the partition wall 212.

The semiconductor modules 12U, 12V, 12W are disposed on the inner bottom surface 171A of the second forming portion 187. The cooler 240 is disposed on an opposite side of the second forming portion 187 with respect to the semiconductor modules 12U, 12V, 12W. The semiconductor modules 12U, 12V, 12W are sandwiched between the cooler 240 and the flow path forming portion 177 in the Z direction. The cooler 240 has a plate shape and includes, inside thereof, a first flow path 205 through which coolant can flow.

The first connecting pipe 220 is passed through the first through hole 213. It can also be said that the first connecting pipe 220 is connected to the first forming portion 184. The first connecting pipe 220 is a tube defining a hollow inside. The first connecting pipe 220 extends in the Z direction. The hollow of the first connecting pipe 220 can also be said to be a first connecting flow path 203 through which coolant flows. An end portion of the first connecting flow path 203 branches into three. One end portion of the first connecting flow path 203 is connected to the fourth flow path 202 in a manner such that coolant can flow. Another end portion of the first connecting flow path 203 is connected to the second flow path 204 in a manner such that coolant can flow. Still another end portion of the first connecting flow path 203 is connected to the first flow path 205 in a manner such that coolant can flow.

The second connecting pipe 230 is passed through the second through hole 214. It can also be said that the second connecting pipe 230 is connected to the first forming portion 184. The second connecting pipe 230 is a tube defining a hollow inside. The second connecting pipe 230 extends in the Z direction. The hollow of the second connecting pipe 230 can also be said to be a second connecting flow path 206 through which coolant flows. An end portion of the second connecting flow path 206 branches into three. One end portion of the second connecting flow path 206 is connected to the third flow path 207 in a manner such that coolant can flow. Another end portion of the second connecting flow path 206 is connected to the second flow path 204 in a manner such that coolant can flow. Still another end portion of the second connecting flow path 206 is connected to the first flow path 205 in a manner such that coolant can flow.

In the cooling module 200, coolant first flows from the supply flow path 201 to the fourth flow path 202. Next, the coolant flows from the fourth flow path 202 to the first connecting flow path 203. Next, the coolant from the first connecting flow path 203 divides and flows into the second flow path 204 and the first flow path 205. Next, the coolant from the second flow path 204 and the first flow path 205 flows into the second connecting flow path 206. The coolant that has passed through the second flow path 204 and the first flow path 205 merges in the second connecting flow path 206. Next, the coolant flows from the second connecting flow path 206 to the first flow path piece 207A of the third flow path 207. Next, the coolant flows from the first flow path piece 207A to the third flow path piece 207C via the second flow path piece 207B. Next, the coolant flows from the third flow path piece 207C to the discharge flow path 208. The coolant that has passed through the discharge flow path 208 is discharged to the outside. In this manner, coolant flows through the cooling module 200. As the coolant supplied from a supply port flows through the flow paths and flows out from a discharge port, cold coolant constantly flows through the flow paths.

### <Arrangements of Respective Electric Components in Housing>

Each of the semiconductor modules 12U, 12V, 12W is sealed by the sealing member 14. Each of the semiconductor modules 12U, 12V, 12W has two main surfaces 14A and side surfaces connecting the two main surfaces 14A. A distance between the two main surfaces 14A may be referred to as a thickness of the corresponding semiconductor module 12U, 12V, 12W. The three semiconductor modules 12U, 12V, 12W are disposed on the flow path forming portion 177 such that the main surfaces 14A of the sealing members 14 overlap the second forming portion 187. The three semiconductor modules 12U, 12V, 12W are thermally connected to the flow path forming portion 177. It can also be said that the semiconductor modules 12U, 12V, 12W have a thickness in the Z direction.

As an example, the three semiconductor modules 12U, 12V, 12W are arranged in the order of the U-phase semiconductor module 12U, the V-phase semiconductor module 12V, and the W-phase semiconductor module 12W from the fourth side wall 172D toward the second side wall 172B. Note that this arrangement order is not limited thereto. The semiconductor modules 12U, 12V, 12W each include, as the side surfaces, a first side surface 14B on a smoothing capacitor 20 side and a second side surface 14C on a motor connector 140 side.

The high-potential-side input terminal 11A, the low-potential-side input terminal 11B, and the signal terminal 11D are exposed from the first side surface 14B. The high-potential-side input terminal 11A and the low-potential-side input terminal 11B extend in the X direction toward the smoothing capacitor 20. The signal terminal 11D includes a first extension portion 11E extending toward the smoothing capacitor 20 and a second extension portion 11F extending from a tip end of the first extension portion 11E toward the control board 15. As an example, the first extension portion 11E extends in the X direction. The second extension portion 11F extends in the Z direction. The motor terminal 11C is exposed from the second side surface 14C. The motor terminal 11C extends in the X direction toward the motor connector 140.

The motor connector 140 includes the connecting busbar 130 and the sealing resin sealing the connecting busbar 130. An end portion of the connecting busbar 130 and the motor terminal 11C are electrically and mechanically connected via a bolt or the like. The connecting busbar 130 extends outside the accommodation space through the motor connector arrangement hole 182. Another end portion of the connecting busbar 130 is connected to a corresponding winding of the motor 4.

The smoothing capacitor 20 is accommodated in the recess 176 of the main body portion 170. In the plan view, the semiconductor modules 12U, 12V, 12W and the smoothing capacitor 20 are disposed in the housing 160 in a manner arranged in the X direction. An upper surface 20A of the smoothing capacitor 20 facing the control board 15 is disposed closer to the control board 15 in the Z direction than the main surfaces 14A of the semiconductor modules 12U, 12V, 12W facing the control board 15. As an example, the smoothing capacitor 20 is provided such that the second end face 25 of the capacitor element 21 faces a bottom of the capacitor case 22, and the first end face 24 of the capacitor element 21 faces the opening of the capacitor case 22. The main surface 14A may be referred to as a first upper surface. The upper surface 20A may be referred to as a second upper surface.

As shown in FIG. 3, in the smoothing capacitor 20, one end of the first terminal 24A and one end of the second terminal 24B are provided on the first end face 24. The first terminal 24A extends in the Y direction toward the busbar insertion hole 181. The second terminal 24B extends in the X direction toward the semiconductor modules 12U, 12V, 12W. One end of the third terminal 25A and one end of the fourth terminal 25B are provided on the second end face 25. The third terminal 25C extends along the bottom surface and the side surface of the capacitor element 21 and then extends in the Y direction toward the busbar insertion hole 181. The fourth terminal 25B extends along the bottom surface and the side surface of the capacitor element 21 and then extends in the X direction toward the semiconductor modules 12U, 12V, 12W. One end of the high-potential-side second connection portion 112 is connected to the other end of the first terminal 24A. The high-potential-side input terminal 11A is connected to the other end of the second terminal 24B. One end of the low-potential-side second connection portion 122 is connected to the other end of the third terminal 25A. The low-potential-side input terminal 11B is connected to the other end of the fourth terminal 25B.

The noise filter 70 is disposed on a side opposite to the semiconductor modules 12U, 12V, 12W with respect to the flow path forming portion 177. The noise filter 70 is fixed to the outer bottom surface 171B of the flow path forming portion 177. The noise filter 70 overlaps the flow path forming portion 177 in the Z direction and overlaps the connecting portion 175 in the X direction. The noise filter 70 is disposed in an overlapping region where a projection region of the flow path forming portion 177 in the Z direction and a projection region of the connecting portion 175 in the X direction overlap. In the present embodiment, more strictly, the entirety of the noise filter 70 overlaps the flow path forming portion 177 in the X direction. Note that the noise filter 70 does not have to entirely overlap the flow path forming portion 177 in the X direction.

As an example, the noise filter 70 is disposed such that the Y capacitor 30 is arranged adjacent to the busbar insertion hole 181 in the X direction, and the magnetic core 60 is arranged adjacent to the motor connector arrangement hole 182 in the X direction. Both the Y capacitor 30 and the magnetic core 60 are fixed to the outer bottom surface 171B of the flow path forming portion 177.

The other ends of the second connection portions 112, 122 are connected to one end of the Y capacitor 30. After extending toward the busbar insertion hole 181, the second connection portions 112, 122 pass through the busbar insertion hole 181 and are electrically connected to the terminals 24A, 24B. The first connection portions 111, 121 are connected to the other ends of the Y capacitor 30. The first connection portions 111, 121 extend toward the terminal block arrangement hole 183. The terminal block 150 is passed through the terminal block arrangement hole 183. The terminal block 150 includes the first connection portions 111, 121 and a sealing resin sealing the first connection portions 111, 121.

One end of each of the first connection portions 111, 121 and the other end of a corresponding one of the second connection portions 112, 122 are electrically and mechanically connected via a bolt or the like. The first connection portions 111, 121 extend into the accommodation space through the terminal block arrangement hole 183 and the sealing resin. The other ends of the first connection portions 111, 121 are electrically connected, inside the accommodation space, to a battery connector 2A connected to the battery 2. Note that the magnetic core 60 is provided so as to annularly cover the portions of the first connection portions 111, 121 between the connection portions with the Y capacitor 30 and the terminal block 150.

### <Advantageous Effects>

The power conversion device 10 includes the semiconductor modules 12U, 12V, 12W, the noise filter 70, the smoothing capacitor 20, the high-potential-side busbar 110, the low-potential-side busbar 120, the housing 160, and the cooler 240. The semiconductor modules 12U, 12V, 12W each have a thickness in the Z direction and have the signal terminal 11D extending in the Z direction and connected to the control board 15. The smoothing capacitor 20 is electrically connected to the semiconductor modules 12U, 12V, 12W. The smoothing capacitor 20 and the battery 2 are connected via the high-potential-side busbar 110 and the low-potential-side busbar 120. The noise filter 70 is electrically or magnetically connected to the high-potential-side busbar 110 and the low-potential-side busbar 120. More specifically, the noise filter 70 is electrically or magnetically connected to the first connection portions 111, 121 and the second connection portions 112, 122.

The housing 160 includes the bottom 171 thermally connected to the semiconductor modules 12U, 12V, 12W, the noise filter 70, and the smoothing capacitor 20. The cooler 240 cools the semiconductor modules 12U, 12V, 12W. The bottom 171 has the inner bottom surface 171A on the control board 15 side and the outer bottom surface 171B on the back side thereof. The bottom 171 includes the flow path forming portion 177, the lower bottom 173, and the connecting portion 175. The lower bottom 173 is disposed at a position farther from the control board 15 in the Z direction than the flow path forming portion 177. The connecting portion 175 connects the flow path forming portion 177 and the lower bottom 173. The flow path forming portion 177 includes, inside thereof, the second flow path 204 disposed on the semiconductor modules 12U, 12V, 12W side, the third flow path 207 disposed on the noise filter 70 side, and the wall 211 separating these flow paths. The semiconductor modules 12U, 12V, 12W are sandwiched between the cooler 240 and the flow path forming portion 177.

The entire bottom 171 is cooled by the coolant. More specifically, the flow path forming portion 177 and the lower bottom 173 are cooled by the coolant. Heat of the semiconductor modules 12U, 12V, 12W is dissipated to the inner bottom surface 171A of the flow path forming portion 177 and the cooler 240. Heat of the noise filter 70 is dissipated to the outer bottom surface 171B of the flow path forming portion 177. Heat of the smoothing capacitor 20 is dissipated to the inner bottom surface 171A of the lower bottom 173. Further, in a state where the semiconductor modules 12U, 12V, 12W are disposed in the flow path forming portion 177, since the semiconductor modules 12U, 12V, 12W are located near the control board 15, even if vibration or the like occurs during use, the connection between the signal terminals 11D and the control board 15 can be kept favorably. While maintaining the favorable connection between the signal terminals 11D and the control board 15, it has become possible to efficiently dissipate heat of the three components, i.e., the semiconductor modules 12U, 12V, 12W, the smoothing capacitor 20, and the noise filter 70, to the bottom 171. Further, since the heat of the semiconductor modules 12U, 12V, 12W, which are main heat-generating components, can be dissipated from both surfaces, the semiconductor modules 12U, 12V, 12W can be efficiently cooled. Furthermore, dead space between the flow path forming portion 177 and the control board 15 is reduced, and an increase in size in the Z direction can be suppressed.

In the present embodiment, the noise filter 70 includes the Y capacitor 30 and the magnetic core 60. The Y capacitor 30 and the magnetic core 60 remove noise components caused by current flowing through the first connection portions 111, 121 and the second connection portions 112, 122. According to this, radiated noise emitted from the first connection portions 111, 121 and the second connection portions 112, 122 can be suppressed. Propagation of radiated noise to the semiconductor modules 12U, 12V, 12W and the control board 15 is suppressed.

The power conversion device 10 further includes the heat dissipation member 80 having the thermal conductivity higher than that of air. In the present embodiment, the heat dissipation member 80 is disposed between the noise filter 70 and the outer bottom surface 171B of the flow path forming portion 177, and between the smoothing capacitor 20 and the inner bottom surface 171A of the lower bottom 173. According to this, heat of the noise filter 70 and heat of the smoothing capacitor 20 can be efficiently dissipated to the bottom 171.

The entire noise filter 70 overlaps the connecting portion 175 with respect to the X direction. In other words, the entire noise filter 70 is disposed in a projection region of the connecting portion 175 in the X direction. According to this, an increase in size of the power conversion device 10 with respect to the Z direction is suppressed.

The continuous portion 178 has the busbar insertion hole 181 penetrating through the inner bottom surface 171A and the outer bottom surface 171B. The busbar insertion hole 181 is a hole through which the second connection portions 112, 122 are passed. The busbar insertion hole 181 is not formed between the semiconductor modules 12U, 12V, 12W and the smoothing capacitor 20 with respect to the X direction. Further, the heat dissipation member 80 is provided between the connecting portion 175 and the smoothing capacitor 20. The connecting portion 175 and the smoothing capacitor 20 are in close contact with each other through the heat dissipation member 80. According to this, heat of the smoothing capacitor 20 can be efficiently dissipated to the connecting portion 175. Further, an increase in size of the power conversion device 10 in the X direction can be suppressed. Complexity of the shape of the lower bottom 173 can be suppressed.

The power conversion device 10 includes two connecting pipes 220, 230 connected to the first forming portion 184. The flow path forming portion 177 further includes the fourth flow path 202 which is non-continuous with the third flow path 207 and to which coolant is first supplied. The first connecting pipe 220 includes, inside thereof, the first connecting flow path 203 that communicates with the first flow path 205, the second flow path 204, and the fourth flow path 202. According to this, heat of the semiconductor modules 12U, 12V, 12W is dissipated to both the coolant flowing through the first flow path 205 and the coolant flowing through the second flow path 204. Heat of the semiconductor modules 12U, 12V, 12W can be efficiently dissipated.

The second connecting pipe 230 includes, inside thereof, the second connecting flow path 206 that communicates with the first flow path 205, the second flow path 204, and the third flow path 207. A flow path through which the coolant that cools the semiconductor modules 12U, 12V, 12W flows is disposed upstream of the third flow path 207 that cools the noise filter 70. In the power conversion device 10, the semiconductor modules 12U, 12V, 12W are main heat-generating components. Since the first flow path 205 and the second flow path 204 are disposed upstream of the third flow path 207, the heat of the semiconductor modules 12U, 12V, 12W can be efficiently dissipated.

The flow path forming portion 177 includes the supply pipe 200A and the discharge pipe 200B. The supply pipe 200A is a pipe connected to the fourth flow path 202 and to which the coolant is supplied. The discharge pipe 200B is a pipe connected to the third flow path 207 and from which the coolant is discharged. The supply pipe 200A and the discharge pipe 200B are disposed at the edge on the one side of the flow path forming portion 177 in the Y direction. According to this, an inlet and an outlet of the coolant can be gathered at one location. Further, an increase in size of the flow path forming portion 177 can be suppressed.

### (Second Embodiment)

FIG. 9 is a cross-sectional view of the power conversion device 10 of the second embodiment. The semiconductor modules 12U, 12V, 12W have the main surfaces 14A facing the control board 15. The smoothing capacitor 20 has the upper surface 20A facing the control board 15. In the second embodiment, the main surfaces 14A are located closer to the control board 15 in the Z direction than the upper surface 20A. To realize this, in the second embodiment, for example, the smoothing capacitor 20 having a smaller size in the Z direction than in the first embodiment is used. As another method, although not shown, the first end face 24 and the second end face 25 are arranged to face each other in the X direction or the Y direction. According to these configurations, the second embodiment also achieves effects similar to those of the first embodiment. Further, an increase in size of the power conversion device 10 in the Z direction can be suppressed.

While the present disclosure has been described in accordance with the embodiments, it is understood that the present disclosure is not limited to the embodiments and structures. The present disclosure also includes various modifications and variations within the scope of equivalents. In addition, various combinations and forms are shown in the present disclosure, and other combinations and forms including only one element thereof, more elements thereof, or fewer elements thereof also fall within the scope and spirit of the present disclosure.

### (Disclosure of Technical Concepts)

This specification discloses a plurality of technical concepts described in the plurality of items listed below. Some items may be described in a multiple dependent form referring to any one of preceding items in a subsequent item. Further, some items may be described in a multiple dependent form referring to another multiple dependent form. These items described in such multiple dependent forms define a plurality of technical concepts.

### (Technical Concept 1)

A power conversion device includes:
a semiconductor module (12U, 12V, 12W) having a thickness in one direction (Z) and including a signal terminal (11D) that extends in the one direction and is connected to a board (15);
a first electrical component (20) electrically connected to the semiconductor module;
a conductive member (111, 121, 112, 122) connecting a battery (2) and the first electrical component;
a second electrical component (70) electrically or magnetically connected to the conductive member;
a housing (160) including a bottom (171) that has an inner bottom surface (171A) facing the board and an outer bottom surface (171B) located on a back side of the inner bottom surface, the semiconductor module, the first electrical component, and the second electrical component being thermally connected to the bottom; and
a cooler (240) including a first flow path (205) that cools the semiconductor module, in which:
   the bottom includes:
      a first placement portion (177) in which the semiconductor module is disposed on an inner bottom surface side and the second electrical component is disposed on an outer bottom surface side;
      a second placement portion (173) disposed at a position farther from the board in the one direction than the first placement portion, and in which the first electrical component is disposed on an inner bottom surface side; and
      a connecting portion (175) connecting the first placement portion and the second placement portion;
   the first placement portion includes, inside thereof, a second flow path (204) disposed adjacent to the semiconductor module, a third flow path (207) disposed adjacent to the second electrical component, and a wall (211) separating the second flow path and the third flow path; and
   the semiconductor module is sandwiched between the cooler and the first placement portion.

### (Technical Concept 2)

In the power conversion device according to Technical Concept 1, the second electrical component includes at least one of a capacitor (30) and a magnetic core (60) that remove noise flowing through the conductive member.

### (Technical Concept 3)

The power conversion device according to Technical Concept 1 or 2, further includes a heat dissipation member (80) that has a thermal conductivity higher than that of air, in which the heat dissipation member is disposed at least one of between the outer bottom surface of the first placement portion and the second electrical component and between the inner bottom surface of the second placement portion and the first electrical component.

### (Technical Concept 4)

In the power conversion device according to Technical Concept 3, in an arrangement direction (X) in which the first electrical component and the second electrical component are arranged, the second electrical component entirely overlaps the connecting portion.

### (Technical Concept 5)

The power conversion device according to any one of Technical Concepts 1 to 4, further includes two connecting pipes (220, 230) connected to the first placement portion, in which the first placement portion further includes a fourth flow path (202) on a same side as the third flow path relative to the wall, the fourth flow path being discontinuous with the third flow path and to which coolant is first supplied, and
one of the two connecting pipes includes, inside thereof, a connecting flow path (203) that connects the first flow path, the second flow path, and the fourth flow path and that supplies the coolant from the fourth flow path to the first flow path and the second flow path.

### (Technical Concept 6)

In the power conversion device according to Technical Concept 5, the connecting flow path is a first connecting flow path, and the other one of the two connecting pipes includes, inside thereof, a second connecting flow path (206) that is different from the first connecting flow path and connects the first flow path, the second flow path, and the third flow path to discharge the coolant from the first flow path and the second flow path to the third flow path.

### (Technical Concept 7)

The power conversion device according to Technical Concept 5 or 6, includes: a supply pipe (200A) connected to the fourth flow path to supply the coolant; and a discharge pipe (200B) connected to the third flow path to discharge the coolant, and in which the supply pipe and the discharge pipe are disposed on a same edge of the first placement portion.

### (Technical Concept 8)

In the power conversion device according to Technical Concept 4, the bottom includes an insertion hole (181) for passing the conductive member, the insertion hole is not formed between the first electrical component and the second electrical component in the arrangement direction, the heat dissipation member is further disposed between the connecting portion and the first electrical component, and the connecting portion and the first electrical component are in close contact with each other through the heat dissipation member.

### (Technical Concept 9)

In the power conversion device according to any one of Technical Concepts 1 to 8, a second upper surface (20A) of the first electrical component facing the board is farther from the board in the one direction than a first upper surface (14A) of the semiconductor module facing the board.

## Claims

1. A power conversion device comprising:
a semiconductor module (12U, 12V, 12W) having a thickness in one direction (Z) and including a signal terminal (11D) that extends in the one direction and is connected to a board (15);
a first electrical component (20) electrically connected to the semiconductor module;
a conductive member (111, 121, 112, 122) connecting a battery (2) and the first electrical component;
a second electrical component (70) electrically or magnetically connected to the conductive member;
a housing (160) including a bottom (171) that has an inner bottom surface (171A) facing the board and an outer bottom surface (171B) located on a back side of the inner bottom surface, the semiconductor module, the first electrical component, and the second electrical component being thermally connected to the bottom; and
a cooler (240) including a first flow path (205) that cools the semiconductor module,
wherein the bottom includes:
a first placement portion (177) in which the semiconductor module is disposed on an inner bottom surface side and the second electrical component is disposed on an outer bottom surface side;
a second placement portion (173) disposed at a position farther from the board in the one direction than the first placement portion, and in which the first electrical component is disposed on the inner bottom surface side; and
a connecting portion (175) connecting the first placement portion and the second placement portion,
wherein the first placement portion includes, inside thereof, a second flow path (204) disposed adjacent to the semiconductor module, a third flow path (207) disposed adjacent to the second electrical component, and a wall (211) separating the second flow path and the third flow path, and
wherein the semiconductor module is sandwiched between the cooler and the first placement portion.

2. The power conversion device according to claim 1, wherein the second electrical component includes at least one of a capacitor (30) and a magnetic core (60) that remove noise flowing through the conductive member.

3. The power conversion device according to claim 2, further comprising:
a heat dissipation member (80) that has a thermal conductivity higher than that of air,
wherein the heat dissipation member is disposed at least one of between the outer bottom surface of the first placement portion and the second electrical component and between the inner bottom surface of the second placement portion and the first electrical component.

4. The power conversion device according to claim 3, wherein the second electrical component entirely overlaps the connecting portion in an arrangement direction (X) in which the first electrical component and the second electrical component are arranged.

5. The power conversion device according to any one of claims 1 to 4, further comprising:
two connecting pipes (220, 230) connected to the first placement portion, wherein the first placement portion further includes a fourth flow path (202) on a same side as the third flow path relative to the wall, the fourth flow path being discontinuous with the third flow path and to which coolant is first supplied, and
wherein one of the two connecting pipes includes, inside thereof, a connecting flow path (203) that connects the first flow path, the second flow path, and the fourth flow path and that supplies the coolant from the fourth flow path to the first flow path and the second flow path.

6. The power conversion device according to claim 5, wherein the connecting flow path is a first connecting flow path, and the other one of the two connecting pipes includes, inside thereof, a second connecting flow path (206) that is different from the first connecting flow path and connects the first flow path, the second flow path, and the third flow path to discharge the coolant from the first flow path and the second flow path to the third flow path.

7. The power conversion device according to claim 6, comprising:
a supply pipe (200A) connected to the fourth flow path to supply the coolant; and
a discharge pipe (200B) connected to the third flow path to discharge the coolant,
wherein the supply pipe and the discharge pipe are disposed on a same edge of the first placement portion.

8. The power conversion device according to claim 4, wherein:
the bottom includes an insertion hole (181) for passing the conductive member;
the insertion hole is not formed between the first electrical component and the second electrical component in the arrangement direction;
the heat dissipation member is further disposed between the connecting portion and the first electrical component; and
the connecting portion and the first electrical component are in close contact with each other through the heat dissipation member.

9. The power conversion device according to any one of claims 1 to 4, wherein a second upper surface (20A) of the first electrical component facing the board is farther from the board in the one direction than a first upper surface (14A) of the semiconductor module facing the board.
